## Europäisches Patentamt
## European Patent Office
## Office européen des brevets

(19)

(11) Publication number: **0 013 743**
**B1**

(12) **EUROPEAN PATENT SPECIFICATION**

(45) Date of publication of patent specification: **21.12.83**

(51) Int. Cl.³: **H 05 K 7/18, H 05 K 5/00, H 05 K 9/00, E 06 B 9/20**

(21) Application number: **79105226.9**

(22) Date of filing: **17.12.79**

(54) Enclosure for data processing apparatus.

(30) Priority: **26.12.78 US 972767**

(43) Date of publication of application:
**06.08.80 Bulletin 80/16**

(45) Publication of the grant of the patent:
**21.12.83 Bulletin 83/51**

(84) Designated Contracting States:
**BE CH DE FR GB IT NL**

(56) References cited:
**DE - A - 2 363 025**
**DE - A - 2 729 547**
**DE - U - 1 878 846**
**DE - U - 7 512 655**

(73) Proprietor: **International Business Machines Corporation**
**Old Orchard Road**
**Armonk, N.Y. 10504 (US)**

(72) Inventor: **Chu, Richard Chao-Fan**
**4 Sun Lane**
**Poughkeepsie, N.Y. 12601 (US)**
Inventor: **Ladue, James Joel**
**29 Lake Oniad Drive**
**Wappingers Falls, N.Y. 12590 (US)**
Inventor: **Shelkofsky, Clifford Inge**
**2A Morehouse Road**
**Poughkeepsie, N.Y. 12603 (US)**

(74) Representative: **Lancaster, James Donald**
**IBM United Kingdom Patent Operations Hursley Park**
**Winchester Hants S021 2JN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Enclosure for data processing apparatus

The invention relates to an enclosure for data processing apparatus which can be used to advantage in locations where it is desired to minimise the space required for, and the impediment caused by, hinging open a door of the enclosure. The enclosure has a very wide range of uses, including, by way of example, use as a cabinet for data processing apparatus.

A data processor and the associated storage and channels are made up of a number of circuit boards and components, apparatus for cooling the components, and power supplies and other supporting circuits. These components are commonly housed in generally rectangular enclosures. The enclosures conventionally have tubular metal frames and rectangular metal panels are attached to the outside of the frames. Some of these panels are hinged to permit access to the processor by service personnel. Such an enclosure has several functions. The rectangular metal panels form an electromagnetic shield that isolates the components inside the enclosure from other electrical apparatus. The enclosure also helps to contain the noise of electrical components such as fans and transformers. Cover panels may support an array of indicators and switches. Also, the enclosure may have a decorative outer finish.

As mentioned, panels of a conventional enclosure may be hinged to the tubular frame so that they can be swung open to give access to the interior of the enclosure. For example, an enclosure may have two panels along its front that are hinged about vertical axes at the ends of the frame to swing open. The panels may be fairly wide and may intrude undesirably into the floor space alongside the processor when they are opened. Processor units are frequently arranged in columns with aisles between the columns, and the invention can reduce the aisle space that is taken up by doors when they are swung open. This can be particularly important where doors of two processors are located oppositely across an aisle and the doors may be simultaneously opened.

Enclosures having sliding doors are also known, each door having a flexible tambour construction comprising a series of interconnected door strips or slats. These doors can be slid away from the entrance to the enclosure into the interior of the enclosure adjacent the side and back walls. These areas within the enclosure must therefore be kept clear, and this can be an unacceptable limitation for example in many data processing cabinets.

German patent 303335 discloses an aircraft hangar with two hinged doors at opposite ends of the hangar entrance. Between the doors are a number of door panels slidable along fixed tracks. Each hinged door is wedge-shaped and has a number of holders for receiving door panels, the holders extending in different radial directions from the door hinge. To open the hangar entrance, the doors are hinged to align the holders in succession with the fixed tracks, a door panel being slid into each aligned holder, and when all the door panels have been loaded into the holders on the doors, the doors are hinged away from the entrance. This is a cumbersome arrangement which would be slow in use.

These disadvantages are reduced by the solution presented in the characterising part of claim 1.

It is also known to provide TV and/or radio cabinets with sliding doors having a flexible tambour construction (DE—U—1 878 846). The sliding door can be slid away from the entrance into the interior of the cabinet housing to be stored there in a folded form.

Drawings

Fig. 1 is a perspective view of a cabinet according to the invention;

Fig. 2 is an enlarged top view of tambour elements of a door of the cabinet of Fig. 1;

Fig. 3 is a top view of a portion of a guide track;

Fig. 4 is a cross-section elevation of a door of the cabinet of Fig. 1 taken along line 4—4 of Fig. 6;

Fig. 5 is a perspective view of the door;

Fig. 6 is a plan view of part of the floor of the door;

Fig. 7 is a partial front elevation of the door;

Fig. 8 is a plan view showing a hinge connection;

Fig. 9 is an enlarged perspective of tambour elements provided with louver elements;

Fig. 10 is a partial perspective of one control panel for the cabinet of Fig. 1;

Fig. 11 is a partial perspective of a second control panel for the cabinet of Fig. 1.

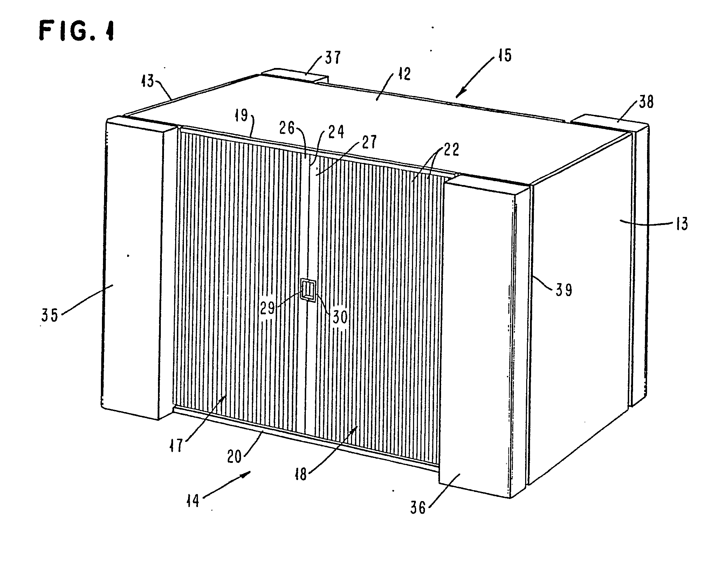

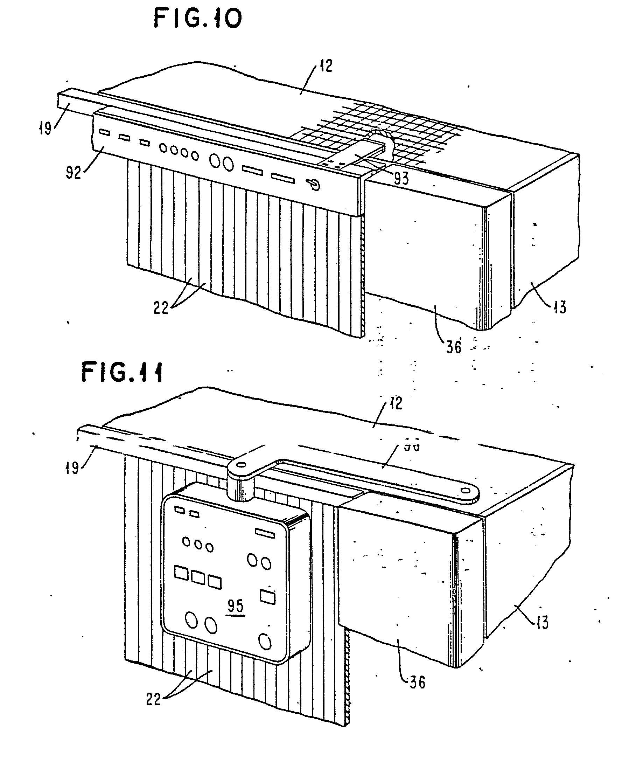

Fig. 1 shows an enclosure in the form of a cabinet for containing data processing apparatus. The rectangular perimeter of the top 12 and an end panel 13 will be familiar from similar arrangements of many present day processors. For reference purposes the drawing is also marked to designate a front 14 and a back 15 of the cabinet, but these terms are arbitrary and the front and back may be similar to dissimilar in structure and function. End panels 13 are conventionally made of steel and have a decorative paint finish and are attached to a tubular metal frame (not shown) that also supports components such as circuit boards and cooling apparatus. The top 12 may be an open egg crate construction (see Fig. 10).

The cabinet of Fig. 1 has two flexible tambour door extensions 17, 18 that can slide in a fixed guide track system that includes an upper track 19 and a lower track 20. The door extensions are made of a series of interconnected tambour elements or slats 22 that will be described later. The two door extensions meet along a line 24 and the innermost tambour elements 26, 27 may be wider than the other elements 22 and carry handles 29, 30 that are used for moving the door extensions along the track system. The track system has a stop (not shown) that prevents either door from being moved across the line 24. The tambour elements 26, 27 carry a conventional locking mechanism to hold the door extensions in their closed position, and the element 26 may carry an inner flange (not shown) that overlaps the other element 27 to provide acoustic and electromagnetic shielding across line 24.

Doors 35, 36 are hinged adjacent the vertical edges (e.g. 39) of the cabinet and each door has a U-shaped guide track so that the associated door extension can be moved completely into its door clear of the fixed tracks 19, 20 and the door can then be swung open to expose the interior of the processor cabinet to allow access to service personnel. A conventional latching mechanism (not shown) is provided for latching each door to the frame of the enclosure. The control for the latch may be incorporated in the handles 29, 30 or the latch control can be located inside the enclosure at a convenient point that is accessible when the tambour door extension has been opened. Each door when containing its tambour door extension is sufficiently compact and lightweight that the assembly may be arranged to be detachable from the enclosure if required. In the enclosure of the drawing, a door covers about one-sixth of the enclosure front and the associated door extension is wider and covers about one-third. The door is only a few inches thick. Thus, when a door extension is moved into its associated door and the door is swung open, the enclosure is open along part of its front and the door projects only a short distance into the aisle in front of the enclosure and only slightly into the lateral space at the end of the enclosure.

As Fig. 1 shows, similar tambour door extensions with doors 37, 38 can be located at the back of the enclosure. A variety of other configurations will be apparent from Fig. 1. For example, an enclosure can be only half the length of the enclosure of Fig. 1 with a single door and door extension along the front and/or back and with the end of the door extension (26 or 27) latching with a mechanism carried by the conventional end panel 13. Similarly, an enclosure of about three-fourths the length of the enclosure of Fig. 1 can have a single wider door extension and a single wider door and the end of the door extension can close against the structure of an end panel 13 or against an inside corner of another enclosure unit when two rectangular enclosures are combined in T or L shapes.

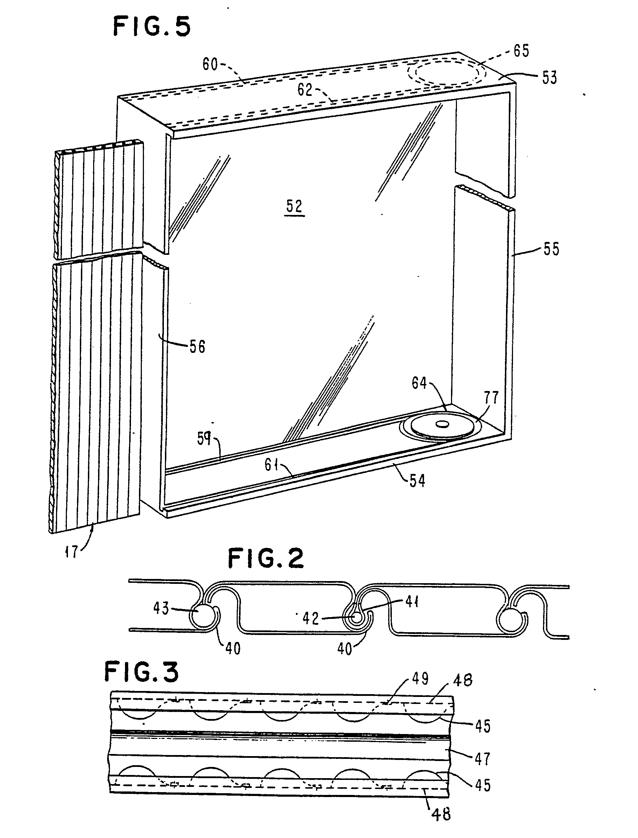

The Tambour Door Extension—Fig. 2

Tambour doors are well known and a variety of tambour elements or slats are suitable for the enclosure of Fig. 1. A data processor enclosure should provide an electrically conductive shield for the enclosed space, and for this, in particular, the door extension should be conductive and the conductive elements should be electrically connected to other conductive components of the enclosure. For example, the tambour elements can be made of metal or other conductive material or they can be painted with conductive paint or backed by a metal foil or screen.

Fig. 2 shows a top view of the preferred tambour construction. Each element is formed by a conventional process in which a flat strip of steel is progressively rolled into the shape shown in Fig. 2 with the edges joined along a flat inner surface. As the door extension is oriented in Fig. 2, the outer surface of the door extension is lowermost in the drawing and the inner surface is uppermost in the drawing. The tambour elements are generally rectangular tubes with complementary hinged structures at each end. Along the right hand edge of each element a portion 40 is folded into a partial cylinder that forms the outer element of a hinge. Along the left hand edge of each element a portion 41 is initially formed in a cylindrical shape about a supporting pin 42 to form the inner element of the hinge. The tambour elements can be assembled by sliding a portion 41 into a portion 40. At the upper and lower edges of the tambour elements, the cylindrical portion 41 and the pin 42 are cut away and they are replaced by a short pin 43 that is swaged or otherwise attached to portion 40 to lock the elements vertically.

The Fixed Track System—Fig. 3

The upper and lower fixed tracks 19, 20 that are shown in Fig. 1 are generally similar and it will simplify the following description to refer primarily to the lower track 20. Fig. 3 shows the lower track viewed from the top. The upper and lower tracks 19, 20 support the door extensions 17, 18 vertically, and against horizontal movement at right angles to their extended planes shown in Fig. 1. In addition, the tracks 19, 20 are constructed to provide electrical shielding at the upper and lower edges of the door extensions, and the track 20 carries metal springs 45 that make sliding electrical contact with the metal or conductive layers of the door extensions to keep the door extensions at the electrical potential of the enclosure frame.

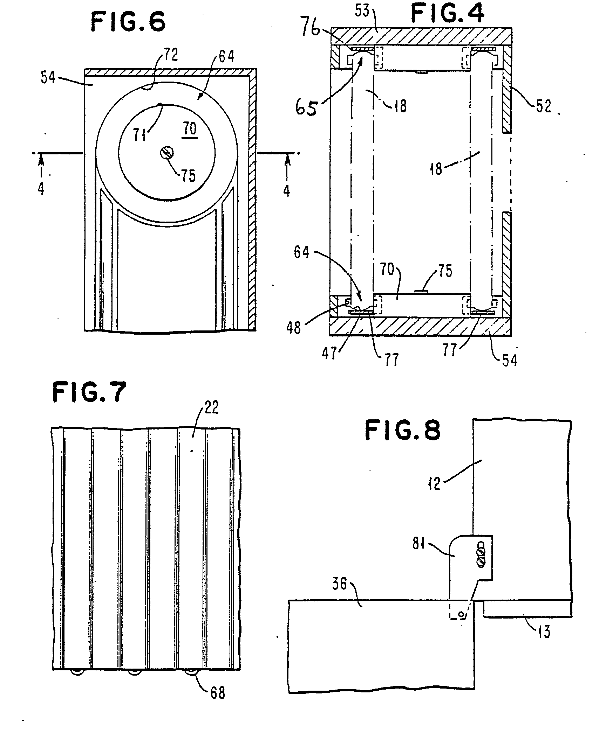

The lower track 20 is generally channel shaped with a groove 47 that helps to center the door extension in the track and with lateral recesses 48 (indicated diagrammatically in Fig. 4) for receiving the contact making springs 45. Springs 45 are connected electrically and mechanically to the channel by means 49 such as screws. The track 20 is only one example of a variety of devices that will support and electrically contact the door extensions along the front of the enclosure.

The Doors — Figs. 4—8

Fig. 5 shows the door viewed from the side that faces the enclosure. It is a generally rectangular open box shape with a front 52, top 53, bottom 54, outer and inner side walls 55, 56, and an open back facing the interior of the enclosure and providing access to the interior of the door. A portion of the associated door extension 17 is shown. (The door extension can easily be removed as shown for maintenance.) The inward facing surfaces of the top and bottom walls 53, 54 carry a U-shaped track having lengths 59, 60 along the front edge, lengths 61, 62, along the back edge and having connecting half-circular portions 64, 65.

The length of the U-shaped track inside a door is slightly longer than half the length of the fixed track 19 separate from the door, and when a door extension is in the extended position of Fig. 1, it still projects slightly into the door so that there is no gap between the door extension and the associated door.

When the door extension is contracted relative to the door from the closed position in Fig. 1 to the open position, it slides along the U-shaped tracks. The curved portions 64, 65 can be made in either of two general forms. In the tambour structure of Fig. 7, the door extension is carried by wheels 68 that ride in the groove 47 of the track. The wheels are preferably carried on small inserts that are forced into the ends of the tambour elements. Wheels may be located on alternate tambour elements as shown in Fig. 7 with wheels on the first two elements to aid moving from tracks 61, 62 of the door to the fixed tracks 19, 20. For a door extension that is carried by wheels, the half circular track section 64 for example can be a simple continuation of the track sections 59, 61 with an inner circular or half circular element 70 (Fig. 6) forming an inner track wall 71 and an edge 72 of the bottom wall 54 forming a complementary outer track wall. Element 70 may be stationary (preferably) or may be rotatable about a shaft 75 that is mounted on the wall 54.

In an alternate construction, the tambour elements do not carry wheels 68 but instead the door extension slides along track portions 59 and 61. The door extension may be supported on small plastic inserts carried by the tambour elements. To carry the door extension smoothly around the half circular track portion 64, the part 70 is made rotatable as already described, but in addition it carries a circular flange 77 (see Fig. 4) that supports the door extension. The upper track half circular portion 65 may be constructed with a part 76 arranged to rotate in the same way as the lower part 70, as is shown in Fig. 4. Alternatively, with either the rotating or non-rotating structure of the lower track portion, the upper track can be non-rotating.

It should be noted that the tambour elements of approximately one half of the door extension never enter the curved parts 64, 65 of the tracks. These elements are supported by the stationary straight track sections 19, 20 or by the straight track lengths 61, 62 of the door. Accordingly, these elements can be attached to a common supporting plate, or otherwise can be formed for example as a unitary plate structure with an outer appearance simulating the remaining tambour elements.

Fig. 8 shows a hinge 81 that is attached to the enclosure frame (not shown) and supports the door 36 to allow it to hinge away from the front of the enclosure.

The U-shaped tracks serve to guide the door extension to a shallow folded form in the associated door. This allows the door to be kept thin, and moreover thinner than if the door extension was caused to roll up in a cylindrical form on the door. As an alternative the U-shaped tracks can be replaced by elongate tracks e.g. of serpentine form, or of flat coil form, to form the door extension into more than two adjacent folds.

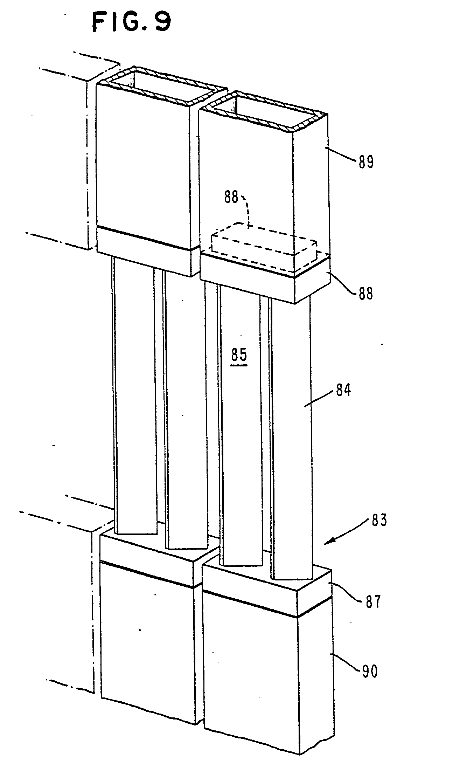

Other Features — Figs. 9—11

In the conventional construction of processor enclosures the flat panels sometimes carry louvers for circulating cooling air and they sometimes support switches and indicators. The end panel 13 can be adapted to provide these conventional functions or these functions can be provided in combination with the tambour door as shown in Figs. 9, 10 and 11.

Fig. 9 shows a structure 83 of two louver elements 84, 85 that are mounted on an upper flange 88 and a lower flange 87 to fit into an upper section 89 and a lower section 90 of a tambour element. These louver elements can be made as long as desired and can be located at any suitable place in the door extension. For example, louver elements about six inches high can be located completely across the bottom of each door extension. (In Fig. 9 the tambour elements are shown schematically and the hinge structure of Fig. 2 has been omitted.)

It will ordinarily be undesirable to locate switches and indicators on the tambour door extension itself. Fig. 10 shows part of a control or electrical circuit component accessory panel 92 that is supported by a hinge 93 at each end in a normal operating position extending along the top of the enclosure between the two doors and in front of the upper track 19 and the door extensions. It can be hinged to a retracted position over the top of the enclosure to permit unimpeded access to the interior of the enclosure when the door extensions are contracted into the doors 35, 36. A short cable (not shown) connects the panel to apparatus inside the enclosure. The drawing, partly broken away, shows the conventional egg crate structure of the enclosure top 12 cut away to receive the hinge 93 flush with the top.

An alternative panel 95 is shown in Fig. 11.

The panel 95 is pivotally supported on an arm 96 that is itself pivotally supported on the enclosure. The panel can normally be positioned closely in front of the door extension so that it does not project significantly beyond the front of the door 36. To allow access to the front of the enclosure the panel can be pivoted out of the way to the side of the enclosure in front of the end wall 13, to provide equivalent access thereto when this position is advantageous to service personnel.

This processor cabinet can be made by common construction techniques that are used for present day processor enclosures and details of construction have generally been omitted where conventional techniques can apply. For example, electromagnetic sealing gaskets that are conventionally used with panels such as end panel 13 can be used to provide an electromagnetic seal between each door and the enclosure frame.

The cabinet described also has a visual advantage. When a series of conventional cabinets are placed side by side, the adjoining unbroken flat surfaces of the cabinets are colored, any slight differences in color are noticeable and are objectionable. Objectionable differences occur if covers are painted with different batches of paint, and it is conventional to paint the covers in sets. With cabinets as shown in Fig. 1, the doors 35, 36 are relatively narrow, and are separated by the visually distinct tambour door extensions 17, 18. Thus with a row of such cabinets, the flat areas of color are broken up in a way that eliminates the undesirable effects of small differences in color. The door extensions need not necessarily have a tambour construction, and can for example be made of a flat flexible sheet e.g. metal/plastic laminate.

## Claims

1. Enclosure for data processing apparatus having at least one hinged door (35), characterised in that the door comprises extension means (17, 18) extendable from the door (35) to provide an extended door area for the enclosure, the door extension means (17, 18) being wider than the door (35) and being guided to a folded form by guide means (61, 64, 59, 62, 65, 69) on the door when it is contracted to the door.

2. Enclosure as claimed in claim 1 in which the door extension means has a flexible tambour construction comprising a series of interconnected door slats (22).

3. Enclosure as claimed in claim 1 or 2 in which the guide means comprises at least one "U"-shaped guide track (61, 59), with a rotatable wheel (70) at the base of the "U" to facilitate guiding the door extension means into said folded form.

4. Enclosure as claimed in any preceding claim having fixed guide track means (19, 20) with which the door extension means engages to be supported and guided thereby when extended from the door, while the door is in its closed position.

5. Enclosure as claimed in any preceding claim arranged to provide an electrically conductive shield for the enclosed space, part of said shield being provided by said door extension means, which is made of metal or has an electrically conductive layer or layers.

6. Enclosure as claimed in claim 5 as dependent on claim 4 in which said fixed guide track means (19, 20) includes electrical contact means (45) to establish electrical contact to the metal or conductive layer or layers of the door extension means, when the door extension means engages the fixed guide track means.

7. Enclosure as claimed in any preceding claim including an electrical circuit component accessory panel (92, 95) positioned on the exterior of the enclosure and hinged to the enclosure so that it can be hinged from a normal position in front of the door extension means when the door extension means is extended from the door, to a retracted position which allows unimpeded access through the opening left when the door extension means is contracted relative to the door.

8. Enclosure as claimed in claim 7 in which the accessory panel (95) can be hinged from the front of the enclosure to the side of the enclosure.

9. Enclosure as claimed in any preceding claim in the form of a cabinet.

10. Enclosure as claimed in claim 9 having at least one access opening provided with two of said hinged doors (35, 36) hinged at opposite ends of the opening, each door having its own said door extension means (17, 18), which door extension means can be extended towards each other to meet and close said opening.

11. Enclosure as claimed in any preceding claim which is provided with air vent means (84, 85).

## Revendications

1. Boitier pour dispositif de traitement de données ayant au moins une porte à charnières (35), caractérisé en ce que la porte comprend des panneaux de prolongement (17, 18) prolongeant la porte afin d'obtenir une embrasure de porte plus importante dans le boitier, les panneaux de prolongement étant plus larges que la porte et repliés par des moyens de guidage (61, 64, 59, 62, 65, 60) sur la porte lorsqu'ils sont rentrés par rapport à la porte.

2. Boitier selon la revendication 1 dans lequel les panneaux de prolongement de porte consistent en une structure à tambour flexible comprenant une série de lamelles (22) de porte interconnectées.

3. Boitier selon la revendication 1 ou 2 dans lequel les moyens de guidage comprennent au moins un rail de guidage en forme de "U" (61, 59) avec une roue rotative (70) à la base du "U" pour faciliter le guidage des panneaux de prolongement de porte en position repliés.

4. Boitier selon l'une quelconque des revendications précédentes présentant des rails de guidage fixes (19, 20) dans lesquels sont engagés les panneaux de prolongement de porte pour y être portés et guidés lorsqu'ils sont en position sortie par rapport à la porte en position fermée.

5. Boitier selon l'une quelconque des revendications précédentes agencé de façon à constituer une protection électriquement conductrice de son volume intérieur, une partie de ladite protection étant assurée par lesdits panneaux de prolongement de porte qui sont en métal et présentent une ou des couches électriquement conductrices.

6. Boitier selon la revendication 5 dépendant de la revendication 4, dans lequel lesdits rails de guidage fixes (19, 20) comprennent des moyens de contact électrique (45) pour établir un contact électrique avec le métal ou la ou les couches conductrices des panneaux de prolongement de porte lorsque ceux-ci sont engagés dans les rails de guidage fixes.

7. Boitier selon l'une quelconque des revendications précédentes comprenant des tableaux auxiliaires d'éléments de circuits électriques (92, 95) disposés sur la partie externe du boitier et articulés par rapport à celui-ci de façon à pouvoir pivoter à partir d'une position normale à l'avant des panneaux de prolongement de porte lorsque ceux-ci sont sortis par rapport à la porte, vers une position rentrée qui permet d'accéder sans aucune gène à l'intérieur du boitier au travers de l'ouverture laissée par les panneaux de prolongement de porte lorsque ceux-ci sont rentrés par rapport à la porte.

8. Boitier selon la revendication 7 dans lequel le tableau auxiliaire (95) peut être basculé de l'avant au côté du boitier.

9. Boitier selon l'une quelconque des revendications précédentes se présentant sous la forme d'une armoire.

10. Boitier selon la revendication 9 ayant au moins un passage d'accès équipé avec deux desdites portes montées sur charnières (35, 36), articulées aux extrémités opposées du passage, chaque porte comportant son propre panneau de prolongement de porte (17, 18) qui peut être sorti pour rejoindre l'autre et fermer ledit passage.

11. Boitier selon l'une des revendications précédentes, équipé de moyens d'aération (84, 85).

**Patentansprüche**

1. Gehäuse für eine Datenverarbeitungsanlage mit mindestens einer Scharniertür (35), dadurch gekennzeichnet, daß die Tür ein Auszugteil (17, 18) aufweist, das aus der Tür derart ausfahrbar ist, daß eine vergrößerte Türöffnung im Gehäuse geschaffen wird, wobei das Auszugteil breiter als die Tür ist und mit Hilfe von an der Tür angebrachten Führungsmitteln (61, 64, 59; 62, 65, 60) faltbar ist, wenn es gegenüber der Tür zusammengeschoben wird.

2. Gehäuse nach Anspruch 1, in dem das Auszugteil eine flexible Trommelstruktur mit einer Reihe von miteinander verbundenen Türlamellen (22) aufweist.

3. Gehäuse nach Anspruch 1 oder 2, in dem die Führungsmittel mindestens eine U-förmige Führungsschiene (61, 59) mit einem an der Basis des "U" angebrachten drehbaren Rad (70) aufweisen, um die Führung des Auszugteils in die zusammengefaltete Stellung zur erleichtern.

4. Gehäuse nach einem der vorhergehenden Ansprüche mit festen Führungsschienen (19, 20), mit denen das Auszugsteil zur Führung in Eingriff kommt, wenn es aus der Tür ausgefahren ist, während die Tür in geschlossener Stellung ist.

5. Gehäuse nach einem der vorhergehenden Ansprüche, das so ausgebildet ist, daß es eine elektrisch leitfähige Abschirmung des Innenraumes aufweist, wobei das Auszugsteil, das entweder aus Metall besteht oder eine oder mehrere elektrisch leitfähige Schichten aufweist, einen Teil der Abschirmung darstellt.

6. Gehäuse nach den Ansprüchen 4 und 5, in dem die festen Führungsschienen (19, 20) elektrische Kontaktmittel (45) aufweisen, um einen elektrischen Kontakt mit dem Metall oder mit der oder den elektrisch leitfähigen Schichten des Auszugteils herzustellen, wenn dieses mit den Führungsschienen in Eingriff kommt.

7. Gehäuse nach einem der vorhergehenden Ansprüche mit einer mit elektrischen Schaltelementen versehenen Zubehörplatte (92, 95), die außerhalb des Gehäuses befindlich und klappbar am Gehäuse so angeordnet ist, daß sie aus einer Normallage vor dem Auszugteil, wenn dieses aus der Tür ausgefahren ist, in eine zurückgezogene Lage geschwenkt werden kann, die unbehinderten Zugang zu der Öffnung erlaubt, die entsteht, wenn das Auszugteil gegenüber der Tür zusammengeschoben ist.

8. Gehäuse nach Anspruch 7, in dem die Zubehörplatte (95) von einer Stellung vor dem Gehäuse in eine Stellung seitwärts des Gehäuses geschwenkt werden kann.

9. Gehäuse nach einem der vorhergehenden Ansprüche in Form eines Schranks.

10. Gehäuse nach Anspruch 9 mit mindestens einer Zugriffsöffnung, die mit zwei an entgegengesetzten Enden der Zugriffsöffnung klappbar angeordneten Scharniertüren (35, 36) versehen ist, wobei jede Tür ihr eigenes Auszugteil (17, 18) aufweist und diese Auszugteile ausgefahren werden können bis sie sich treffen, um so die Zugriffsöffnung zu schließen.

11. Gehäuse nach einem der vorhergehenden Ansprüche, das mit Lüftungsmitteln (84, 85) versehen ist.

**FIG. 1**

## FIG.5

## FIG.2

## FIG.3

2

**FIG.6**

**FIG.4**

**FIG.7**

**FIG.8**

# FIG. 9

89

88

88

85

84

83

87

90

## FIG.10

## FIG.11